# FASCICULE DE BREVET EUROPEEN

(11) **EP 3 182 617 B1**
(45) Date de publication et mention de la délivrance du brevet: **24.01.2018**
(21) Numéro de dépôt: 16202539.9
(22) Date de dépôt: 06.12.2016
(51) Int. Cl.: H04B 10/69, H04L 7/00

(54) **RÉCEPTEUR DE DONNÉES OPTIQUES MUNI D'UN DÉTECTEUR DE PHASE RELATIVE**
OPTISCHER EMPFÄNGER MIT RELATIVER PHASENDETEKTION
OPTICAL RECEIVER COMPRISING A RELATIVE PHASE DETECTOR

(30) Priorité: 18.12.2015 FR 1562863
(43) Date de publication de la demande: 21.06.2017
(73) Titulaire: COMMISSARIAT À L'ÉNERGIE ATOMIQUE ET AUX ÉNERGIES ALTERNATIVES, 75015 Paris (FR)
(72) Inventeur: POLSTER, Robert, 12353 Berlin (DE); MIRO PANADES, Ivan, 38000 Grenoble (FR); THONNART, Yvain, 38100 Grenoble (FR)
(74) Mandataire: Thibon, Laurent

(56) Documents cités:
- US-A- 5 754 606
- US-A1- 2014 064 744
- US-A1- 2015 326 384

## Description

### Domaine de l'invention

La présente description concerne le domaine des récepteurs de données optiques, et en particulier un récepteur de données optiques capable de recevoir un signal optique de faible amplitude.

### Exposé de l'art antérieur

Les liaisons optiques assurent des débits de transmission de données élevés avec de faibles puissances, et fournissent ainsi une solution viable pour remplacer des interconnexions ordinaires en cuivre entre des circuits intégrés. La réception optique est basée sur la capture, en utilisant un dispositif photosensible comme une photodiode, d'un signal lumineux qui est en général codé de façon numérique, et qui peut avoir un niveau de puissance aussi faible que 10 µW. Le dispositif photosensible génère par exemple un petit courant qui est transformé par le récepteur optique en un signal de tension numérique. US2014/0064744 décrit un récepteur utilisant un signal de synchronisation. Une difficulté dans la réception de données optiques est de pouvoir détecter avec précision le signal optique à faible puissance. En effet, le courant généré par l'impulsion de données du signal optique peut être aussi faible que 10 µA.

On a donc besoin dans la technique d'un récepteur optique ayant une forte sensibilité tout en conservant une faible complexité et une faible consommation d'énergie.

### Résumé

Un objet de modes de réalisation de la présente description est de résoudre au moins partiellement un ou plusieurs problèmes de l'art antérieur.

Selon un aspect, on prévoit un récepteur optique adapté à convertir un signal optique reçu en un changement de phase d'un signal de synchronisation pour générer un premier signal de synchronisation modifié et pour générer un signal de données en comparant le premier signal de synchronisation modifié à un signal de référence.

Selon un mode de réalisation, le signal optique reçu est un signal modulé sur la base des données à transmettre vers le récepteur optique.

Selon un mode de réalisation, le récepteur optique comprend : une entrée adaptée à recevoir le signal de synchronisation comportant des fronts montants et descendants ; une première branche couplée à l'entrée et comprenant au moins une porte logique adaptée à propager le signal de synchronisation et à générer le premier signal de synchronisation modifié ; une deuxième branche couplée à l'entrée et comprenant au moins une porte logique adaptée à propager le signal de synchronisation et à générer un deuxième signal de synchronisation modifié formant le signal de référence ; une photodiode adaptée à convertir le signal optique reçu en un signal de courant, la photodiode étant couplée à au moins l'une des première et deuxième branches pour induire, sur la base du signal de courant, une différence de phase entre les fronts montants ou descendants des premier et deuxième signaux de synchronisation modifiés ; et un détecteur de phase relative adapté à générer le signal de données en détectant les phases relatives de fronts montants ou descendants des premier et deuxième signaux de synchronisation modifiés.

Selon un mode de réalisation, la photodiode est couplée de telle sorte que le signal de courant provoque un changement dans la pente d'un premier front montant ou descendant du signal de synchronisation se propageant dans au moins l'une des première et deuxième branches, au moins l'une des première et deuxième branches comprenant un comparateur adapté à convertir le changement de pente en un déphasage du premier front montant ou descendant.

Selon un mode de réalisation, le front montant ou descendant est une transition de tension entre des premier et deuxième niveaux de tension, le comparateur est un dispositif à transistors adapté à générer une transition de tension sur sa sortie lorsque la tension sur son entrée croise un niveau de seuil, et le comparateur est adapté de telle sorte que le niveau de seuil soit supérieur ou inférieur d'au moins 10 % à un point milieu entre les premier et deuxième niveaux de tension.

Selon un mode de réalisation, la première branche comprend une première porte logique connectée à l'entrée et la photodiode est couplée à une sortie de la première porte logique.

Selon un mode de réalisation, la deuxième branche comprend une deuxième porte logique connectée à l'entrée, et la photodiode est couplée entre la sortie de la première porte logique et une sortie de la deuxième porte logique.

Selon un mode de réalisation, la première branche comprend une deuxième porte logique ayant un noeud d'entrée couplé à l'entrée et ayant un premier noeud d'entrée de tension d'alimentation couplé à un premier rail de tension d'alimentation par l'intermédiaire d'une première source de courant, et la photodiode est couplée au premier noeud d'entrée de tension d'alimentation.

Selon un mode de réalisation, la deuxième branche comprend une deuxième porte logique ayant un noeud d'entrée couplé à l'entrée et ayant un premier noeud d'entrée de tension d'alimentation couplé au premier rail de tension d'alimentation par l'intermédiaire d'une deuxième source de courant, la photodiode étant couplée entre les premiers noeuds d'entrée de tension d'alimentation des deuxièmes portes logiques des première et deuxième branches.

Selon un mode de réalisation, la photodiode est couplée entre les première et deuxième branches.

Selon un mode de réalisation, le détecteur de phase relative est adapté à détecter les phases relatives de fronts montants des premier et deuxième signaux de synchronisation modifiés, le récepteur optique comprenant en outre : une troisième branche couplée à l'entrée et comprenant au moins une porte logique adaptée à propager le signal de synchronisation et à générer un troisième signal de synchronisation modifié ; une quatrième branche couplée à l'entrée et comprenant au moins une porte logique adaptée à propager le signal de synchronisation et à générer un quatrième signal de synchronisation modifié ; et un autre détecteur de phase relative adapté à générer un autre signal de données en détectant les phases relatives de fronts descendants des troisième et quatrième signaux de synchronisation modifiés.

Selon un mode de réalisation, la photodiode est couplée de telle sorte que le signal de courant provoque un changement dans la pente d'un premier front montant du signal de synchronisation se propageant dans au moins l'une des première et deuxième branches, et d'un premier front descendant du signal de synchronisation se propageant dans au moins l'une des troisième et quatrième branches, et les première et deuxième branches comprennent chacune un premier comparateur adapté à générer une transition de tension sur sa sortie lorsque la tension sur son entrée croise un niveau de seuil, les premiers comparateurs étant adaptés de sorte que le niveau de seuil soit supérieur d'au moins 10 % à un point milieu entre les premier et deuxième niveaux de tension, et les troisième et quatrième branches comprennent chacune un deuxième comparateur adapté à générer une transition de tension sur sa sortie lorsque la tension sur son entrée croise un niveau de seuil, les deuxièmes comparateurs étant adaptés de sorte que le niveau de seuil soit inférieur d'au moins 10 % à un point milieu entre les premier et deuxième niveaux de tension.

Selon un mode de réalisation, les premier et deuxième comparateurs sont formés par des inverseurs.

Selon un mode de réalisation, le détecteur de phase relative comprend un détecteur avance-retard comprenant : un dispositif de mémorisation bistable constitué d'une paire d'inverseurs couplés de façon croisée entre des premier et deuxième noeuds de sortie du détecteur avance-retard ; au moins un premier commutateur couplé entre les premier et deuxième noeuds de sortie et contrôlé sur la base des premier et deuxième signaux de synchronisation modifiés ; un deuxième commutateur contrôlé sur la base du premier signal de synchronisation modifié et couplé entre le premier noeud et un premier rail de tension d'alimentation ; et un troisième commutateur contrôlé sur la base du deuxième signal de synchronisation modifié et couplé entre le deuxième noeud et le premier rail de tension d'alimentation.

Selon un mode de réalisation, ledit au moins un premier commutateur comprend une paire de premiers commutateurs couplés en série entre les premier et deuxième noeuds de sortie, un premier commutateur de la paire étant contrôlé sur la base du premier signal de synchronisation modifié, et un deuxième commutateur de la paire étant contrôlé sur la base du deuxième signal de synchronisation modifié.

Selon un mode de réalisation, ledit au moins un premier commutateur comprend en outre un autre commutateur couplé entre les commutateurs de la paire de premiers commutateurs et contrôlé par un signal d'activation pour activer sélectivement le détecteur de phase relative.

### Brève description des dessins

Les caractéristiques et avantages susmentionnés et d'autres apparaîtront clairement avec la description détaillée suivante de modes de réalisation, donnés à titre d'illustration et non de limitation, en faisant référence aux dessins joints dans desquels :
la figure 1 illustre schématiquement une liaison optique selon un exemple de réalisation ;
la figure 2 illustre schématiquement un récepteur optique pour recevoir un signal de données optiques selon un exemple de réalisation de la présente description ;
la figure 3 illustre schématiquement un récepteur optique pour recevoir un signal de données optiques selon un autre exemple de réalisation de la présente description ;
la figure 4 est un chronogramme illustrant un exemple de signaux dans le récepteur des figures 2 et 3 selon un exemple de réalisation de la présente description ;
la figure 5A est un chronogramme illustrant des exemples de signaux dans le récepteur des figures 2 et 3 selon un autre exemple de réalisation de la présente description ;
la figure 5B illustre schématiquement une porte logique du récepteur optique des figures 2 et 3 selon un exemple de réalisation de la présente description ;
la figure 6 illustre schématiquement un détecteur avance-retard du récepteur optique des figures 2 et 3 plus en détail selon un exemple de réalisation de la présente description ; et
la figure 7 illustre schématiquement un récepteur optique pour recevoir un signal de données optiques selon un autre exemple de réalisation de la présente description.

### Description détaillée

Dans la présente description, le terme "connecté" est utilisé pour désigner une connexion électrique directe entre des éléments, alors que le terme " couplé" est utilisé pour désigner une connexion électrique entre des éléments qui peut être directe, ou qui peut se faire par l'intermédiaire d'un ou plusieurs autres composants comme des résistances, des condensateurs ou des transistors. En outre, tel qu'il est utilisé ici, le terme "sensiblement" est utilisé pour désigner une plage de ±10 % autour de la valeur en question.

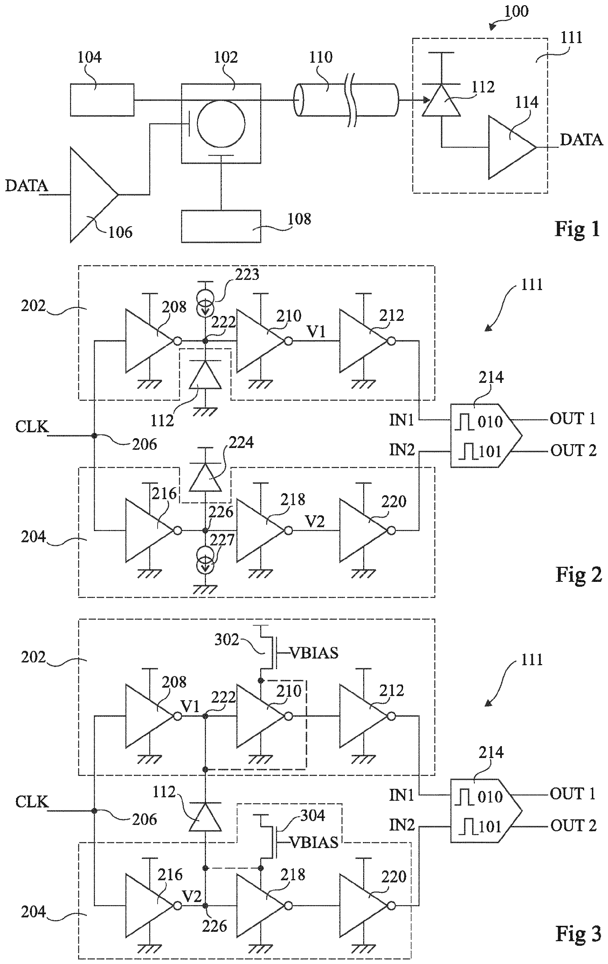

La figure 1 illustre schématiquement une liaison optique 100. Comme cela est illustré, sur un côté émetteur, un modulateur 102 module un faisceau laser généré par un laser 104 sur la base d'un signal fourni par un dispositif de pilotage 106. Dans certains modes de réalisation, le modulateur 102 est aussi contrôlé par un signal provenant d'un circuit de contrôle de température 108. Le dispositif de pilotage 106 reçoit un signal de données DATA à émettre. Le modulateur 102 produit un signal optique, qui est transmis par l'intermédiaire d'un guide d'onde 110 vers le côté récepteur de la liaison optique. Sur le côté récepteur, le signal optique est reçu par un récepteur optique 111 constitué d'une photodiode 112 et d'un circuit de détection de données 114. La photodiode 112 convertit le signal optique en un courant électrique. Le circuit de détection de données 114 détecte le signal de données sur la base du courant généré par la photodiode 112.

La figure 2 illustre le récepteur optique 111 plus en détail selon un exemple de réalisation. Le récepteur optique 111 comprend par exemple une branche 202 et une branche 204, chaque branche étant couplée à une ligne d'entrée 206 pour recevoir un signal d'horloge CLK. Chacune des branches 202, 204 comprend par exemple une pluralité de portes logiques couplées en série. Dans l'exemple de la figure 2, les portes logiques sont des inverseurs, bien que dans des variantes de réalisation on puisse utiliser d'autres types de portes logiques. La branche le 202 comprend par exemple une connexion en série d'inverseurs 208, 210 et 212 couplés entre la ligne d'entrée 206 et une entrée d'un détecteur de phase relative 214. La branche 204 comprend par exemple une connexion en série d'inverseurs 216, 218 et 220 couplés entre la ligne d'entrée 206 et une autre entrée du détecteur de phase relative 214. Cependant, dans des variantes de réalisation, chaque branche 202, 204 couplée comprend seulement une porte logique, ou un nombre différent de portes logiques.

Le signal d'horloge CLK comprend par exemple des transitions de tension entre des niveaux de tension hauts et bas. Chacun de ces fronts montants et descendants a une certaine pente qui dépend de diverses caractéristiques physiques des éléments du circuit, comme les capacités d'entrée des inverseurs constituant chaque branche, les niveaux de tension, etc. La photodiode 112 est par exemple couplée à l'une des branches 202 ou 204, ou aux deux, de sorte que, sur la base du signal optique, la pente des fronts montants et/ou descendants se propageant dans une branche est modifiée par rapport à l'autre branche.

Le détecteur de phase relative 214 détecte par exemple les phases relatives de fronts montants ou descendants du signal de synchronisation modifié IN1 sur la sortie de la branche 202 et du signal de synchronisation modifié IN2 sur la sortie de la branche 204, et génère le signal de sortie de données correspondant en conséquence. Par "phase relative" on entend l'ordre temporel dans lequel surviennent les fronts. Dans un mode de réalisation, le détecteur de phase relative 214 est un détecteur de phase relative avance-retard qui génère des signaux de sortie OUT1, OUT2, comme on va le décrire plus en détail ci-après.

Dans l'exemple de la figure 2, la photodiode 112 a sa cathode couplée à un noeud 222 sur la sortie de l'inverseur 208, et son anode couplée à une tension d'alimentation VDD. Ainsi, lorsqu'une impulsion optique est reçue par la photodiode 112, un courant va être généré par la photodiode 112 déchargeant ainsi la capacité d'entrée de l'inverseur 210. Si cette impulsion optique arrive pendant un front d'horloge montant du signal d'horloge CLK au niveau de l'inverseur 210, elle va tendre à diminuer le gradient de la pente du front d'horloge montant, alors que si cette impulsion optique arrive pendant un front d'horloge descendant du signal d'horloge CLK au niveau de l'inverseur 210, elle va tendre à augmenter le gradient de la pente du front d'horloge descendant. Comme cela est décrit plus en détail ci-après, le signal d'horloge CLK est par exemple synchronisé avec le signal de données optiques de telle sorte que des impulsions du signal optique surviennent pendant des fronts montants et/ou descendants du signal d'horloge. Dans certains modes de réalisation, en l'absence de signal optique, la photodiode 112 laisse passer un courant constant, qui sera appelé ici courant d'obscurité, et une source de courant 223 est par exemple couplée entre le noeud de 222 et la tension d'alimentation pour annuler ce courant d'obscurité et/ou pour assurer un étalonnage.

Dans certains modes de réalisation, une autre photodiode 224 est couplée dans la branche 204, par exemple entre un noeud 226 sur la sortie de l'inverseur 216 et la tension d'alimentation. Le signal optique reçu est par exemple fourni aux deux photodiodes 112 et 224, et elles induisent des effets opposés dans les branches 202, 204, accentuant par cela la différence de phase entre les branches. Comme la photodiode 112, la photodiode 224 peut laisser passer un courant d'obscurité qui peut être annulé par une source de courant 227 couplée entre le noeud 226 et la masse.

En variante, la photodiode 224 pourrait être une photodiode factice, qui ne reçoit pas le signal optique. Dans un tel cas, plutôt que d'être couplée de manière opposée à la photodiode 112, elle est par exemple couplée de la même façon, par exemple entre le noeud 226 et la masse, de sorte que les branches 202, 204 sont identiques excepté en ce qui concerne la présence du signal optique au niveau de la photodiode 112.

En outre, dans des variantes de réalisation, la photodiode 112 pourrait être couplée à un point différent dans la branche 202 et/ou 204. Le point de la branche 202 et/ou 204 sur lequel la photodiode est connectée est par exemple isolé de la ligne d'entrée 206 par au moins une porte logique, de sorte qu'elle n'influence pas le signal se propageant dans les deux branches 202, 204 de la même façon. Dans certains modes de réalisation, il y a au moins une porte logique dans chaque branche 202, 204 après le point sur lequel la photodiode 112 est connectée, ces portes logiques transformant le front présentant un changement de gradient en un front ayant un gradient relativement raide et un déphasage.

La figure 3 illustre le récepteur optique 111 selon une variante de réalisation similaire au mode de réalisation de la figure 2, et les éléments similaires portent les mêmes références et ne seront pas décrits de nouveau en détail. Dans le mode de réalisation de la figure 3, la photodiode 112 a par exemple sa cathode couplée au noeud 222 à la sortie de l'inverseur 208 de la branche 202, et son anode couplée au noeud 226 à la sortie de l'inverseur 216 de la branche 204. De cette façon, une impulsion optique arrivant sur la photodiode 112 va charger la capacité d'entrée de l'inverseur 218 et décharger la capacité d'entrée de l'inverseur 210. Bien que cela ne soit pas représenté en figure 3, dans certains modes de réalisation les sources de courant 223 et 227 de la figure 2 pourraient aussi être prévues dans le circuit de la figure 3 couplées respectivement aux noeuds 222 et 226.

En variante, plutôt que d'être couplée entre les noeuds 222 et 226, la photodiode 114 pourrait être couplée entre des lignes d'alimentation des inverseurs 210, 218, comme cela est représenté par des lignes en pointillés en figure 3. Par exemple, un transistor 302 est couplé par ses noeuds de conduction principaux entre le rail d'alimentation positive VDD et le noeud d'entrée d'alimentation positive de l'inverseur 210. De façon similaire, un transistor 304 est par exemple couplé par ses noeuds de conduction principaux entre le rail d'alimentation positive VDD et le noeud d'entrée d'alimentation positive de l'inverseur 218. Les transistors 302, 304 sont par exemple contrôlés par une tension de polarisation V_{BIAS} de sorte qu'ils se comportent comme des sources de courant, le courant généré par chacune de ces sources de courant étant fonction des dimensions du transistor respectif 302, 304 et du niveau de la tension de polarisation V_{BIAS}. La photodiode 112 est par exemple couplée entre les noeuds d'entrée d'alimentation positive des inverseurs 210 et 218, de sorte qu'une impulsion optique arrivant sur la photodiode 112 va réduire la tension d'alimentation sur l'inverseur 210 et augmenter la tension d'alimentation sur l'inverseur 218, altérant ainsi le gradient d'un front montant ou descendant propagé par les branches 202 et 204.

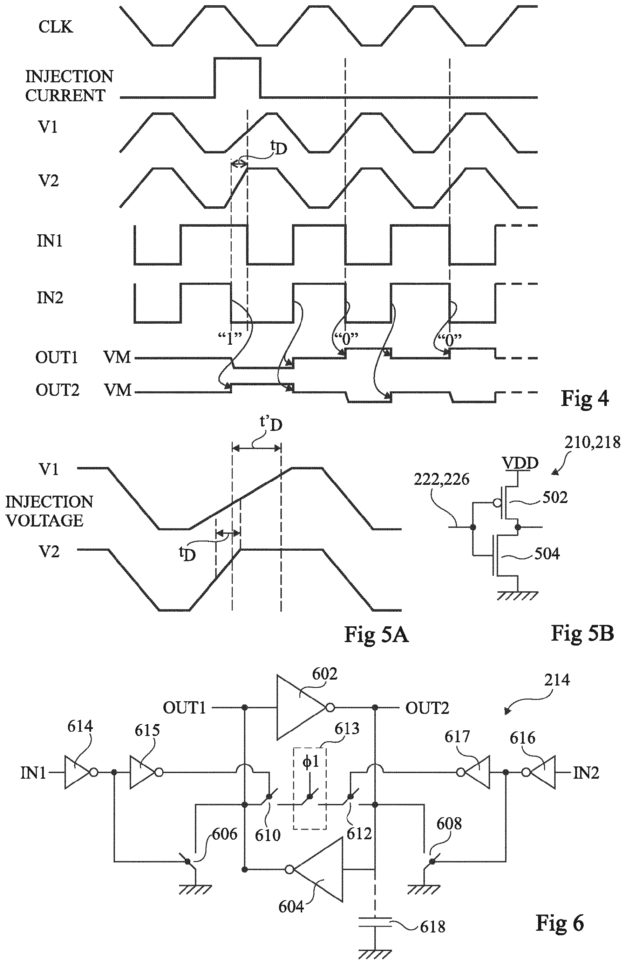

La figure 4 est un chronogramme illustrant un exemple des signaux suivants dans le récepteur optique 111 des figures 2 et 3 : le signal d'horloge CLK, un courant (INJECTION COURANT) injecté par la photodiode 112, les signaux de tension V1 sur la sortie de l'inverseur 208 et V2 sur la sortie de l'inverseur 216, le signal de synchronisation modifié IN1 sur la sortie de la branche 202, le signal de synchronisation modifié IN2 sur la sortie de la branche 204, et le signal de sortie OUT1, OUT2 du détecteur de phase relative 214.

Le signal d'horloge CLK est par exemple un signal à onde carrée ayant des fronts montants et descendants en pente. En l'absence d'impulsion optique, le courant injecté par la photodiode est par exemple proche de 0 µA, ou à un niveau constant donné par les sources de courant 223, 227, et ainsi les signaux V1 et V2 sont sensiblement égaux à la forme inversée du signal d'horloge CLK. Cependant, lorsqu'une impulsion de courant est injectée par la photodiode pendant un front descendant du signal d'horloge CLK, la pente du front montant correspondant des signaux V1 et V2 est altérée. Dans l'exemple de la figure 4, le gradient de la pente du front montant du signal V1 est réduit, tandis que le gradient de la pente du front montant du signal V2 est augmenté, mais cela va dépendre de la configuration particulière de la photodiode 112. En supposant que les inverseurs 210, 212 et 218, 220 changent leur état de sortie lorsque le signal d'entrée croise un niveau de seuil sensiblement égal au point milieu entre les tensions d'alimentation haute et basse, par exemple VDD/2, cela va entraîner une différence de temps t_{D} représentée en figure 4 entre les instants où ce seuil est croisé pour les signaux V1 et V2. Une fois que les signaux V1 et V2 se sont propagés par l'intermédiaire d'un ou plusieurs autres inverseurs dans chaque branche 202, 204, les signaux IN1 et IN2 ont ainsi des fronts descendants ayant une différence de phase égale à t_{D}. En effet, le front descendant du signal IN1 arrive par exemple à un temps t_{D} après le front correspondant du signal IN2.

Le détecteur de phase relative 214 génère par exemple des tensions de sortie OUT1 et OUT2, dont chacune est à un niveau métastable VM jusqu'à ce qu'un front descendant du signal IN1 ou IN2 arrive. Le niveau métastable est par exemple au point milieu entre les tensions d'alimentation haute et basse, qui est par exemple situé à sensiblement VDD/2. En réponse à un front descendant du signal IN2 arrivant avant un front montant du signal IN1, le signal OUT2 passe par exemple à l'état haut, et le signal OUT1 passe à l'état bas. Les états métastables sont par exemple réinitialisés pendant une impulsion haute des signaux IN1, IN2. En réponse à un front descendant du signal IN1 arrivant avant un front descendant du signal IN2, le signal OUT1 passe par exemple à l'état haut, et le signal OUT2 passe à l'état bas.

En l'absence d'un signal optique, les fronts montants et descendants des signaux IN1 et IN2 vont survenir sensiblement en même temps. Le détecteur de phase relative 214, et/ou l'une ou l'autre des deux branches 202, 204, ou les deux, sont par exemple polarisées de façon à favoriser un état donné des signaux de sortie OUT1, OUT2 pour de tels cas. Par exemple, les tailles des transistors et le niveau de tension d'alimentation d'une ou plusieurs des portes logiques de la branche 204 sont sélectionnés de telle sorte que, sans signal optique, les fronts du signal IN2 vont survenir après les fronts du signal IN1. Cela est représenté dans l'exemple de la figure 4, où des bits de données à "0" sont générés par le signal de sortie OUT1 qui passe à l'état haut lorsqu'aucun signal optique n'est présent.

La figure 5A et un chronogramme illustrant les signaux V1 et V2 pendant les fronts montants qui surviennent pendant l'impulsion courante. Comme cela est illustré, dans le cas où les inverseurs 210 et 218 ont des niveaux de tension de seuil se produisant sensiblement au niveau du point milieu entre les tension d'alimentation haute et basse, la différence de phase induite par le changement dans la pente des fronts montants va être t_{D} comme dans l'exemple de la figure 4. Cette différence de temps peut être amplifiée si les portes logiques 210 et 218 sont adaptées pour avoir des niveaux de seuil différents de VDD/2. Par exemple, la figure 5A illustre un exemple dans lequel le niveau de seuil est augmenté à sensiblement 0,9*VDD, et ainsi la différence de phase est maintenant augmentée à t_{D}'. Dans le cas de fronts descendants des signaux V1 et V2, le niveau de seuil est par exemple diminué afin d'amplifier la différence de phase entre les branches. Par exemple, le niveau de seuil est augmenté ou diminué pour se trouver à au moins 10 %, et par exemple à 30 % ou plus, au-dessus ou en dessous du point milieu entre les tensions d'alimentation haute et basse. Ce décalage dans le niveau de seuil est par exemple obtenu en adaptant les tailles des transistors des dispositifs logiques 210 et 218, comme on va maintenant le décrire en faisant référence à la figure 5B.

La figure 5B illustre schématiquement les inverseurs 210, 218 selon un exemple de réalisation. Chaque inverseur 210, 218 est par exemple mis en oeuvre par un transistor PMOS 502 et un transistor NMOS 504 couplés en série par leurs noeuds de conduction principaux entre la tension d'alimentation VDD et la masse. Les grilles des transistors 502, 504 sont couplées au noeud 222 dans le cas de l'inverseur 210, et au noeud 226 dans le cas de l'inverseur 218. Les drains des transistors 502, 504 fournissent le noeud de sortie des inverseurs 210, 218. Les dimensions du transistor PMOS 502 et du transistor NMOS 504 sont par exemple choisies de telle sorte que l'inverseur soit non équilibré. Par exemple, dans un inverseur équilibré, la largeur Wp du transistor PMOS est sensiblement le double de la largeur Wₙ du transistor NMOS. Si la largeur Wₚ est augmentée ou si la largeur Wₙ est diminuée, la tension de déclenchement à laquelle l'inverseur commute va monter. Cela signifie qu'un front montant sur le noeud d'entrée de 222, 226 de l'inverseur doit atteindre un niveau relativement élevé afin d'activer le transistor 504 et d'amener le noeud de sortie à une tension basse. En variante, si la largeur Wₚ est diminuée ou si la largeur Wₙ est augmentée, la tension de déclenchement à laquelle l'inverseur commute va descendre.

Plutôt que d'être mis en oeuvre par des inverseurs non équilibrés, les dispositifs logiques 210 et 218 pourraient être mis en oeuvre par des comparateurs recevant des tensions de référence appropriées pour modifier le niveau de tension auquel ils sont déclenchés.

La figure 6 illustre le détecteur de phase relative 214 plus en détail selon un exemple de réalisation dans lequel il est réalisé par un détecteur avance-retard. Le détecteur avance-retard 214 comprend par exemple un circuit de mémorisation bistable constituée de deux inverseurs 602 et 604 couplés de façon croisée entre les noeuds de sortie OUT1 et OUT2 du détecteur avance-retard (502).

Le noeud de sortie OUT1 est couplé à la masse par l'intermédiaire d'un commutateur 606, et le noeud de sortie OUT2 est couplé à la masse par l'intermédiaire d'un commutateur 608. En outre, les noeuds de sortie OUT1 et OUT2 sont couplés entre eux par la connexion en série de deux commutateurs 610 et 612. Dans certains modes de réalisation, un autre commutateur 613 est aussi couplé entre les commutateurs 610 et 612, et est contrôlé par un signal de phase φ1, ce qui permet au détecteur avance-retard 214 d'être activé ou désactivé, comme on va le décrire plus en détail ci-après. On supposera que les commutateurs 606, 608, 610 et 612 sont mis à l'état conducteur par un niveau haut du signal de commande appliqué, et mis à l'état non conducteur par un niveau bas du signal de commande appliqué. Par exemple, les commutateurs sont basés sur des transistors NMOS. Cependant, dans des variantes de réalisation ce pourrait être l'inverse.

Le commutateur 610 est contrôlé sur la base du signal de synchronisation modifié IN1. Par exemple, des inverseurs 614 et 615 sont couplés en série entre la ligne fournissant le signal de synchronisation modifié IN1 et le noeud de commande du commutateur 610. De façon similaire, le commutateur 612 est contrôlé sur la base du signal de synchronisation modifié IN2. Par exemple, des inverseurs 616 et 617 sont couplés en série entre la ligne fournissant le signal de synchronisation modifié IN2 et le noeud de commande du commutateur 612. Le commutateur 606 est par exemple contrôlé par la sortie de l'inverseur 614, et le commutateur 608 est par exemple contrôlé par la sortie de l'inverseur 616. L'exemple de la figure 6 est basé sur un détecteur destiné à détecter une différence de phase entre des fronts descendants des signaux IN1, IN2, mais il pourrait être adapté pour détecter une différence de phase entre des fronts montants en supprimant les inverseurs 614 et 616.

Optionnellement, un circuit de déséquilibrage est prévu pour déséquilibrer le circuit bistable du détecteur avance-retard. En particulier, lorsque les signaux de synchronisation modifiés IN1 et IN2 sont en phase, le circuit de déséquilibrage amène par exemple la sortie du détecteur avance-retard 502 à favoriser l'un des états. Par exemple, le circuit de déséquilibrage comprend un condensateur 618 couplé au noeud de sortie OUT2. La capacité du condensateur 618 est par exemple relativement faible, par exemple sensiblement égale à 1 fF.

En fonctionnement, le signal φ1 est par exemple activé pour activer le détecteur avance-retard 214, et initialement, les deux signaux de synchronisation modifiés IN1, IN2 sont à l'état haut, et ainsi les sorties OUT1 et OUT2 son couplées entre elles par les commutateurs 610, 612. Les tensions sur ces noeuds sont ainsi au niveau intermédiaire VM représenté dans le chronogramme de la figure 4. Lorsque le signal de synchronisation modifié IN1 présente un front descendant arrivant avant un front descendant du signal de synchronisation modifié IN2, le commutateur 610 est ouvert, et le commutateur 606 est fermé, de sorte que la tension OUT1 est amenée vers le niveau de masse. Cela entraîne que la tension OUT2 va aller vers le niveau de tension d'alimentation. L'arrivée d'un front descendant du signal de synchronisation modifié IN2 ne peut plus changer l'état du circuit bistable. Lorsque les signaux de synchronisation modifiés IN1, IN2 passent à l'état haut, les tensions de sortie OUT1 et OUT2 sont réinitialisées par les commutateurs 610, 612 au niveau intermédiaire VM.

Ainsi, on peut voir que la connexion en série des commutateurs 610 et 612 contrôlés respectivement sur la base des signaux de synchronisation modifiés IN1 et IN2 permet que l'état stable de la bascule formée par les inverseurs 602, 604 soit libéré par celui de ces signaux qui arrivera le premier. Ainsi le détecteur 214 est peu sensible aux disparités induites par des variations du processus de fabrication.

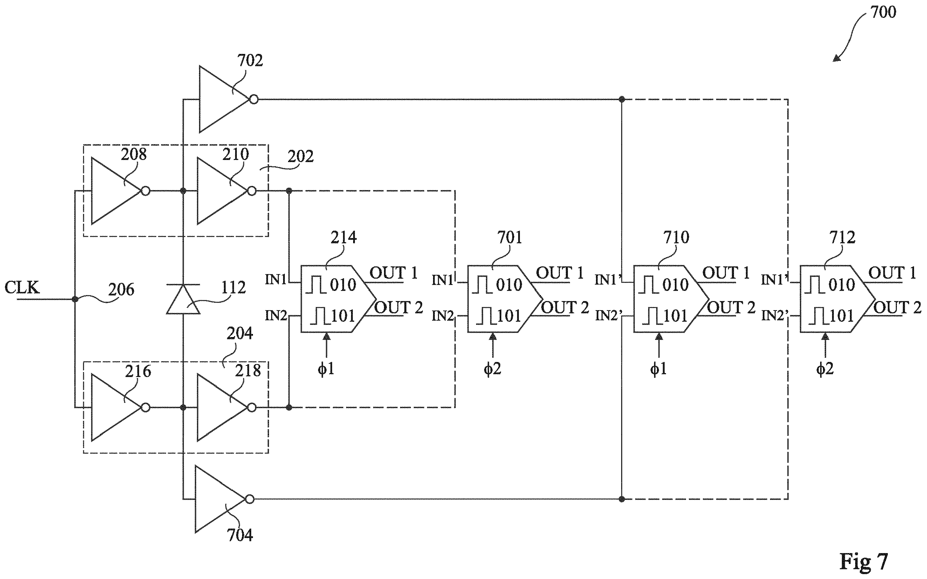

La figure 7 illustre schématiquement un récepteur optique 700 selon un autre exemple de réalisation dans lequel il est adapté à fonctionner à un débit de données double en recevant des signaux à la fois sur les fronts montants et sur les fronts descendants du signal d'horloge. Certains des éléments du récepteur optique 700 de la figure 7 sont les mêmes que des éléments des figures 2 et 3, et ces éléments portent les mêmes références et ne seront pas décrits de nouveau en détail.

Le récepteur optique 700 comprend par exemple seulement les inverseurs 208 et 210 dans la branche 202, et les inverseurs 216 et 218 dans la branche 204. Dans l'exemple illustré, la photodiode 112 est couplée entre les noeuds 222 et 226 comme dans le mode de réalisation de la figure 3, bien que dans des variantes de réalisation elle puisse être couplée de manière différente. Les sorties des inverseurs 210 et 218 fournissent par exemple les signaux de synchronisation IN1, IN2 modifiés au détecteur avance-retard 214.

Dans certains modes de réalisation, un autre détecteur avance-retard 701 et prévu couplé aux sorties des inverseurs 210, 218. Les deux détecteurs 214 et 701 sont par exemple mis en oeuvre par le circuit de la figure 6, bien qu'ils soient par exemple adaptés à détecter la phase de fronts montants des signaux IN1, IN2, et ainsi les inverseurs 614 et 616 sont par exemple omis. Le commutateur 613 du détecteur avance-retard 214 est par exemple contrôlé par un signal de phase φ1, et le commutateur 613 du détecteur avance-retard 701 est contrôlé par un signal de phase φ2, les signaux de phase φ1 et φ2 étant hauts pendant des périodes alternées de sorte que les détecteurs 214 et 701 opèrent de manière entrelacée dans le temps sur des fronts montants alternés des signaux IN1, IN2.

Une autre branche est par exemple formée par une porte logique 702 ayant son entrée couplée à la sortie de l'inverseur 208 de la branche 202, et encore une autre branche est par exemple formée par une porte logique 704 ayant son entrée couplée à la sortie de l'inverseur 216 de la branche 204. Les portes logiques 702 et 704 sont par exemple des inverseurs. La sortie de la porte 702 fournit un signal de synchronisation modifié IN1', et est couplée à une entrée d'un autre détecteur de phase relative 710, qui est par exemple mis en oeuvre par le détecteur avance-retard de la figure 6. La sortie de la porte 704 fournit un signal de synchronisation modifié IN2', et est couplée à l'autre entrée du détecteur de phase relative 710. Le détecteur 710 détecte par exemple la différence de phase entre les fronts descendants des signaux IN1' et IN2'.

Dans certains modes de réalisation, encore un autre détecteur de phase relative 712 est prévu couplé aux sorties des inverseurs 702 et 704. Le détecteur de phase relative 710 est par exemple contrôlé par le signal de phase φ1, tandis que le détecteur de phase relative 712 est par exemple contrôlé par le signal de phase φ2, de sorte que ces détecteurs de phase relative opèrent de manière entrelacée dans le temps d'une manière similaire aux détecteurs de phase relative 214 et 701.

Les inverseurs 210 et 218 sont par exemple adaptés pour avoir un niveau de seuil supérieur à la tension milieu entre leurs tensions d'alimentation de haute et basse, de sorte que la différence de phase induite par la photodiode 112 sur les fronts montants est amplifiée. Les inverseurs 702 et 704 sont par exemple adaptés à avoir un niveau de seuil inférieur à la tension milieu entre leurs tensions d'alimentation haute et basse, de sorte que la différence de phase induite par la photodiode 112 sur des fronts descendants est amplifiée.

Un avantage des modes de réalisation décrits ici est que le récepteur optique a une sensibilité élevée et une consommation d'énergie relativement faible. En outre, le détecteur avance-retard tel que décrit ici en relation avec la figure 6 présente l'avantage d'avoir une vitesse de fonctionnement particulièrement élevée, ce qui permet par exemple de détecter le signe de la différence de phase pour des différences de phase de 2 ps ou moins entre les signaux de synchronisation modifiés IN1, IN2.

Avec la description ainsi faite d'au moins un mode de réalisation illustratif, diverses altérations, modifications et améliorations apparaîtront facilement à l'homme de l'art. Par exemple, il sera clair pour l'homme de l'art qu'on a décrit ici des modes de réalisation basés sur des transistors MOS, et que des variantes de réalisation pourraient être au moins partiellement basées sur d'autres technologies de transistors telles que la technologie bipolaire.

En outre, l'homme de l'art saura facilement comment le rail d'alimentation positive et le rail de masse pourraient être intervertis dans les divers modes de réalisation, et plutôt que la tension de masse, on pourrait utiliser un niveau de tension d'alimentation différent, comme une tension négative.

En outre, il sera clair pour l'homme de l'art que les divers éléments décrits en relation avec les divers modes de réalisation pourraient être combinés, dans des variantes de réalisation, selon diverses combinaisons.

## Revendications

1. Récepteur optique adapté à convertir un signal optique modulé reçu en un changement de phase d'un signal de synchronisation (CLK) pour générer un premier signal de synchronisation modifié (IN1) et pour générer un signal de données (OUT1, OUT2) en comparant le premier signal de synchronisation modifié (IN1) à un signal de référence (IN2).

2. Récepteur optique selon la revendication 1, comprenant :
une entrée (206) adaptée à recevoir le signal de synchronisation (CLK) comportant des fronts montants et descendants ;
une première branche (202) couplée à l'entrée (206) et comprenant au moins une porte logique (208, 210, 212) adaptée à propager le signal de synchronisation et à générer le premier signal de synchronisation modifié (IN1) ;
une deuxième branche (204) couplée à l'entrée (206) et comprenant au moins une porte logique (216, 218, 220) adaptée à propager le signal de synchronisation et à générer un deuxième signal de synchronisation modifié (IN2) formant le signal de référence ;
une photodiode (112) adaptée à convertir le signal optique reçu en un signal de courant, la photodiode (112) étant couplée à au moins l'une des première et deuxième branches (202, 204) pour induire, sur la base du signal de courant, une différence de phase entre des fronts montants ou descendants des premier et deuxième signaux de synchronisation modifiés ; et
un détecteur de phase relative (214) adapté à générer le signal de données (OUT1, OUT2) en détectant les phases relatives de fronts montants ou descendants des premier et deuxième signaux de synchronisation modifiés (IN1, IN2).

3. Récepteur optique selon la revendication 2, dans lequel la photodiode (112) est couplée de telle sorte que le signal de courant provoque un changement dans la pente d'un premier front montant ou descendant du signal de synchronisation se propageant dans au moins l'une des première et deuxième branches (202, 204), au moins l'une des première et deuxième branches comprenant un comparateur (210, 218) adapté à convertir le changement de pente en un déphasage du premier front montant ou descendant.

4. Récepteur optique selon la revendication 3, dans lequel le front montant ou descendant est une transition de tension entre des premier et deuxième niveaux de tension, et dans lequel le comparateur est un dispositif à transistors adapté à générer une transition de tension sur sa sortie lorsque la tension sur son entrée croise un niveau de seuil, dans lequel le comparateur est adapté de sorte que le niveau de seuil soit supérieur ou inférieur d'au moins 10 % à un point milieu entre les premier et deuxième niveaux de tension.

5. Récepteur optique selon l'une quelconque des revendications 2 à 4, dans lequel la première branche (202) comprend une première porte logique (208) connectée à l'entrée (206) et la photodiode (112) est couplée à une sortie de la première porte logique.

6. Récepteur optique selon la revendication 5, dans lequel la deuxième branche (204) comprend une deuxième porte logique (216) connectée à l'entrée (206), et dans lequel la photodiode (112) est couplée entre la sortie de la première porte logique (210) et une sortie de la deuxième porte logique.

7. Récepteur optique selon l'une quelconque des revendications 2 à 4, dans lequel la première branche (202) comprend une deuxième porte logique (210) ayant un noeud d'entrée couplé à l'entrée (206) et ayant un premier noeud d'entrée de tension d'alimentation couplé à un premier rail de tension d'alimentation (VDD) par l'intermédiaire d'une première source de courant (302), dans lequel la photodiode (112) est couplée au premier noeud d'entrée de tension d'alimentation.

8. Récepteur optique selon la revendication 7, dans lequel la deuxième branche (204) comprend une deuxième porte logique (218) ayant un noeud d'entrée couplé à l'entrée (206) et ayant un premier noeud d'entrée de tension d'alimentation couplé au premier rail de tension d'alimentation (VDD) par l'intermédiaire d'une deuxième source de courant (304), dans lequel la photodiode (112) est couplée entre les premiers noeuds d'entrée de tension d'alimentation des deuxièmes portes logiques des première et deuxième branches (202, 204).

9. Récepteur optique selon l'une quelconque des revendications 2 à 8, dans lequel la photodiode (112) est couplée entre les première et deuxième branches (202, 204).

10. Récepteur optique selon l'une quelconque des revendications 2 à 9, dans lequel le détecteur de phase relative (214) est adapté à détecter les phases relatives de fronts montants des premier et deuxième signaux de synchronisation modifiés, le récepteur optique comprenant en outre :
une troisième branche couplée à l'entrée (206) et comprenant au moins une porte logique (702) adaptée à propager le signal de synchronisation et à générer un troisième signal de synchronisation modifié (IN1') ;
une quatrième branche couplée à l'entrée (206) et comprenant au moins une porte logique (704) adaptée à propager le signal de synchronisation et à générer un quatrième signal de synchronisation modifié (IN2') ; et
un autre détecteur de phase relative (710) adapté à générer un autre signal de données en détectant les phases relatives de fronts descendants des troisième et quatrième signaux de synchronisation modifiés.

11. Récepteur optique selon la revendication 10, dans lequel la photodiode (112) est couplée de telle sorte que le signal de courant provoque un changement dans la pente d'un premier front montant du signal de synchronisation se propageant dans au moins l'une des première et deuxième branches (202, 204), et d'un premier front descendant du signal de synchronisation se propageant dans au moins l'une des troisième et quatrième branches, et dans lequel les première et deuxième branches comprennent chacune un premier comparateur (210, 218) adapté à générer une transition de tension sur sa sortie lorsque la tension sur son entrée croise un niveau de seuil, dans lequel les premiers comparateurs sont adaptés de sorte que le niveau de seuil soit supérieur d'au moins 10 % à un point milieu entre les premier et deuxième niveaux de tension, et dans lequel les troisième et quatrième branches comprennent chacune un deuxième comparateur (702, 704) adapté à générer une transition de tension sur sa sortie lorsque la tension sur son entrée croise un niveau de seuil, dans lequel les deuxièmes comparateurs sont adaptés de sorte que le niveau de seuil soit inférieur d'au moins 10 % à un point milieu entre les premier et deuxième niveaux de tension.

12. Récepteur optique selon la revendication 11, dans lequel les premier et deuxième comparateurs (210, 218, 702, 704) sont formés par des inverseurs.

13. Récepteur optique selon l'une quelconque des revendications 2 à 12, dans lequel le détecteur de phase relative (214) comprend un détecteur avance-retard comprenant :
un dispositif de mémorisation bistable constitué d'une paire d'inverseurs (602, 604) couplée de façon croisée entre des premier et deuxième noeuds de sortie (OUT1, OUT2) du détecteur avance-retard ;
au moins un premier commutateur (610) couplé entre les premier et deuxième noeuds de sortie (OUT1, OUT2) et contrôlé sur la base des premier et deuxième signaux de synchronisation modifiés (IN1, IN2) ;
un deuxième commutateur (606) contrôlé sur la base du premier signal de synchronisation modifié (IN1) et couplé entre le premier noeud (OUT1) et un premier rail de tension d'alimentation ; et
un troisième commutateur (608) contrôlé sur la base du deuxième signal de synchronisation modifié (IN2) et couplé entre le deuxième noeud (OUT2) et le premier rail de tension d'alimentation.

14. Récepteur optique selon la revendication 13, dans lequel ledit au moins un premier commutateur comprend une paire de premiers commutateurs (610, 612) couplés en série entre les premier et deuxième noeuds de sortie (OUT1, OUT2), un premier commutateur (610) de la paire étant contrôlé sur la base du premier signal de synchronisation modifié (IN1), et un deuxième commutateur (612) de la paire étant contrôlé sur la base du deuxième signal de synchronisation modifié (IN2).

15. Récepteur optique selon la revendication 14, dans lequel ledit au moins un premier commutateur comprend en outre un autre commutateur (613) couplé entre les commutateurs de la paire de premiers commutateurs (610, 612) et contrôlé par un signal d'activation (φ1) pour activer sélectivement le détecteur de phase relative (214).

## Patentansprüche

1. Ein optischer Empfänger geeignet zum Umwandeln eines empfangenen modulierten optischen Signals in eine Phasenänderung eines Synchronisierungs- bzw. Zeitsteuersignals (CLK) zum Erzeugen eines ersten modifizierten Zeitsteuersignals (IN1) und zum Erzeugen eines Datensignals (OUT1, OUT2) durch Vergleichen des ersten modifizierten Zeitsteuersignals (IN1) mit einem Referenzsignal (IN2).

2. Optischer Empfänger gemäß Anspruch 1, der Folgendes aufweist:
einen Eingang(206) geeignet zum Empfangen des Zeitsteuersignals (CLK), das steigende und fallende Kanten besitzt;
einen ersten Zweig (202), der mit dem Eingang (206) gekoppelt ist und wenigstens ein Logikgatter (208, 210, 212) aufweist, das zum Fortpflanzen des Zeitsteuersignals und zum Erzeugen des ersten modifizierten Zeitsteuersignals (IN1) geeignet ist;
ein zweiter Zweig (204), der mit dem Eingang (206) gekoppelt ist und wenigstens ein Logikgatter (216, 218, 220) aufweist, das zum Fortpflanzen des Zeitsteuersignals und zum Erzeugen eines zweiten modifizierten Zeitsteuersignals (IN2), das das Referenzsignal bildet, geeignet ist;
eine Fotodiode (112), die geeignet ist zum Umwandeln des empfangen optischen Signals in ein Stromsignal, wobei die Fotodiode (112) mit wenigstens einem der ersten und zweiten Zweige (202, 204) gekoppelt ist, um basierend auf dem Stromsignal eine Phasendifferenz zwischen steigenden und fallenden Kanten des ersten und zweiten modifizierten Zeitsteuersignals zu erzeugen; und
ein Relativphasendetektor (214), der geeignet ist zum Erzeugen des Datensignals (OUT1, OUT2) durch Detektieren der relativen Phasen der steigenden und fallenden Kanten der ersten und zweiten modifizierten Zeitsteuersignale (IN1, IN2).

3. Optischer Empfänger gemäß Anspruch 2, wobei die Fotodiode (112) so gekoppelt ist, das das Stromsignal eine Änderung in der Steigung der steigenden oder fallenden Kante des Zeitsteuersignals, die sich durch wenigstens einen der ersten und zweiten Zweige (202, 204) fortpflanzt, versursacht, wobei wenigstens einer der ersten und zweiten Zweige einen Komparator (210, 218) aufweist, der geeignet ist zum Umwandeln der Änderung der Steigung in eine Phasenverschiebung der ersten steigenden oder fallenden Kante.

4. Optischer Empfänger gemäß Anspruch 3, wobei die steigende oder fallende Kante ein Spannungsübergang zwischen ersten und zweiten Spannungsniveaus ist, und wobei der Komparator ein Transistorgerät ist, das geeignet ist zum Erzeugen eines Spannungsübergangs an seinem Ausgang, wenn die Spannung an seinem Eingang ein Schwellenwertniveau überquert, wobei der Komparator so ist, dass das Schwellenwertniveau wenigstens 10 Prozent höher oder niedriger als ein Mittelpunkt zwischen den ersten und zweiten Spannungsniveaus ist.

5. Optischer Empfänger gemäß einem der Ansprüche 2 bis 4, wobei der erste Zweig (202) ein erstes Logikgatter (208) aufweist, das mit dem Eingang (206) verbunden ist, und die Fotodiode (112) mit einem Ausgang des ersten Logikgatters gekoppelt ist.

6. Optischer Empfänger gemäß Anspruch 5, wobei der zweite Zweig (204) ein zweites Logikgatter (216) aufweist, das mit dem Eingang (206) verbunden ist, und wobei die Fotodiode (112) zwischen dem Ausgang des ersten Logikgatters (210) und einem Ausgang des zweiten Logikgatters gekoppelt ist.

7. Optischer Empfänger gemäß einem der Ansprüche 2 bis 4, wobei der erste Zweig (202) ein zweites Logikgatter (210) aufweist, das einen Eingangsknoten besitzt, der mit dem Eingang (206) gekoppelt ist, und einen ersten Versorgungsspannungs-Eingangsknoten besitzt, der mit einer ersten Versorgungsspannungsschiene (VDD) über eine erste Stromquelle (302) gekoppelt ist, wobei die Fotodiode (112) mit dem ersten Versorgungsspannungs-Eingangsknoten gekoppelt ist.

8. Optischer Empfänger gemäß Anspruch 7, wobei der zweite Zweig (204) ein zweites Logikgatter (218) aufweist, das einen Eingangsknoten besitzt, der mit dem Eingang (206) gekoppelt ist, und einen ersten Versorgungsspannungs-Eingangsknoten besitzt, der mit der ersten Versorgungsspannungsschiene (VDD) über eine zweite Stromquelle (304) gekoppelt ist, wobei die Fotodiode (112) zwischen dem ersten Versorgungsspannungs-Eingangsknoten und dem zweiten Logikgatter der ersten und zweiten Zweige (202, 204) gekoppelt ist.

9. Optischer Empfänger gemäß einem der Ansprüche 2 bis 8, wobei die Fotodiode (112) zwischen den ersten und zweiten Zweigen (202, 204) gekoppelt ist.

10. Optischer Empfänger gemäß einem der Ansprüche 2 bis 9, wobei der Relativphasendetektor (214) geeignet ist zum Detektieren der relativen Phasen der steigenden Kanten der ersten und zweiten modifizierten Zeitsteuersignale, wobei der optische Empfänger ferner Folgendes aufweist:
einen dritten Zweig, der an den Eingang (206) gekoppelt ist und wenigstens ein Logikgatter (702) aufweist, das geeignet ist zum Fortpflanzen des Zeitsteuersignals und Erzeugen eines dritten modifizierten Zeitsteuersignals (IN1');
einen vierten Zweig, der an den Eingang (206) gekoppelt ist und wenigstens ein Logikgatter (704) aufweist, das geeignet ist zum Fortpflanzen des Zeitsteuersignals und Erzeugen eines vierten modifizierten Zeitsteuersignals (IN2'); und
einen weiteren Relativphasendetektor (710), der geeignet ist zum Erzeugen eines weiteren Datensignals durch Detektieren der relativen Phasen der fallenden Katen der dritten und vierten modifizierten Zeitsteuersignale.

11. Optischer Empfänger gemäß Anspruch 10, wobei die Fotodiode (112) so gekoppelt ist, dass das Stromsignal eine Änderung in der Steigung der ersten steigenden Kante des Zeitsteuersignals verursacht, das sich durch wenigstens einen der ersten und zweiten Zweige (202, 204) fortpflanzt, und einer ersten fallenden Kante des Zeitsteuersignals, das sich durch wenigstens einen der dritten und vierten Zweige fortpflanzt, und wobei die ersten und zweiten Zweige jeweils einen ersten Komparator (210, 218) aufweisen, der geeignet ist zum Erzeugen eines Spannungsübergangs an seinem Ausgang, wenn die Spannung an seinem Eingang ein Schwellenwertniveau überquert, wobei die ersten Komparatoren so sind, das das vorbestimmte Niveau wenigstens 10 Prozent höher als ein Mittelpunkt zwischen den ersten und zweiten Spannungsniveaus ist, und wobei die dritten und vierten Zweige jeweils einen zweiten Komparator (702, 704) aufweisen, der geeignet ist zum Erzeugen eines Spannungsübergangs an seinem Ausgang, wenn die Spannung an seinem Eingang ein Schwellenwertniveau überquert, wobei die zweiten Komparatoren so sind, das das vorbestimmte Niveau wenigstens 10 Prozent niedriger als ein Mittelpunkt zwischen den ersten und zweiten Spannungsniveaus ist.

12. Optischer Empfänger gemäß Anspruch 11, wobei die ersten und zweiten Komparatoren (210, 218, 702, 704) durch Inverter gebildet werden.

13. Optischer Empfänger gemäß einem der Ansprüche 2 bis 12, wobei der Relativphasendetektor (214) einen Früh-Spät-Detektor aufweist, der Folgendes aufweist:
eine bistabile Speichervorrichtung, die aus einem Paar von Invertern (602, 604) gebildet ist, die zwischen ersten und zweiten Ausgangsknoten (OUT1, OUT2) des Früh-Spät-Detektors über Kreuz gekoppelt sind;
wenigstens einen ersten Schalter (610), der zwischen den ersten und zweiten Ausgangsknoten (OUT1, OUT2) gekoppelt ist, und basierend auf den ersten und zweiten modifizierten Zeitsteuersignalen (IN1, IN2) gesteuert werden;
einen zweiten Schalter (606), der basierend auf dem ersten modifizierten Zeitsteuersignal (IN1) gesteuert wird und zwischen dem ersten Knoten (OUT1) und einer ersten Versorgungsspannungsschiene gekoppelt ist; und
einen dritten Schalter (608), der basierend auf dem zweiten modifizierten Zeitsteuersignal (IN2) gesteuert wird und zwischen dem zweiten Knoten (OUT2) und der ersten Versorgungsspannungsschiene gekoppelt ist.

14. Optischer Empfänger gemäß Anspruch 13, wobei der wenigstens eine erste Schalter ein Paar erster Schalter (610, 612) aufweist, die zwischen den ersten und zweiten Ausgangsknoten (OUT1, OUT2) in Reihe gekoppelt sind, wobei ein erster Schalter (610) des Paares basierend auf dem ersten modifizierten Zeitsteuersignal (IN1) gesteuert wird, und ein zweiter Schalter (612) des Paares basierend auf dem zweiten modifizierten Zeitsteuersignal (IN2) gesteuert wird.

15. Optischer Empfänger gemäß Anspruch 14, wobei der wenigstens eine erste Schalter ferner einen weiteren Schalter (613) aufweist, der zwischen den Schaltern des Paares von ersten Schaltern (610, 612) gekoppelt ist und durch ein Aktivierungssignal (Φ1) zum selektiven Aktivieren des relativen Phasendetektors (214) gesteuert wird.

## Claims

1. An optical receiver adapted to convert a received modulated optical signal into a phase change of a timing signal (CLK) to generate a first modified timing signal (IN1) and to generate a data signal (OUT1, OUT2) by comparing the first modified timing signal (IN1) with a reference signal (IN2).

2. The optical receiver of claim 1, comprising:
an input (206) adapted to receive the timing signal (CLK) having rising and falling edges;
a first branch (202) coupled to the input (206) and comprising at least one logic gate (208, 210, 212) adapted to propagate the timing signal and to generate the first modified timing signal (IN1);
a second branch (204) coupled to the input (206) and comprising at least one logic gate (216, 218, 220) adapted to propagate the timing signal and to generate a second modified timing signal (IN2) forming said reference signal;
a photodiode (112) adapted to convert the received optical signal into a current signal, the photodiode (112) being coupled to at least one of the first and second branches (202, 204) to induce, based on the current signal, a phase difference between rising or falling edges of the first and second modified timing signals; and
a relative phase detector (214) adapted to generate the data signal (OUT1, OUT2) by detecting the relative phases of rising or falling edges of the first and second modified timing signals (IN1, IN2).

3. The optical receiver of claim 2, wherein the photodiode (112) is coupled so that the current signal causes a change in the slope of a first rising or falling edge of the timing signal propagating through at least one of the first and second branches (202, 204), at least one of the first and second branches comprising a comparator (210, 218) adapted to convert the change of slope into a phase shift of the first rising or falling edge.

4. The optical receiver of claim 3, wherein the rising or falling edge is a voltage transition between first and second voltage levels, and wherein the comparator is a transistor device adapted to generate a voltage transition at its output when the voltage at its input crosses a threshold level, wherein the comparator is adapted such that the threshold level is at least 10 percent higher or lower than a mid-point between the first and second voltage levels.

5. The optical receiver of any of claims 2 to 4, wherein the first branch (202) comprises a first logic gate (208) connected to the input (206) and the photodiode (112) is coupled to an output of the first logic gate.

6. The optical receiver of claim 5, wherein the second branch (204) comprises a second logic gate (216) connected to the input (206), and wherein the photodiode (112) is coupled between the output of the first logic gate (210) and an output of the second logic gate.

7. The optical receiver of any of claims 2 to 4, wherein the first branch (202) comprises a second logic gate (210) having an input node coupled to the input (206) and having a first supply voltage input node coupled to a first supply voltage rail (VDD) via a first current source (302), wherein the photodiode (112) is coupled to the first supply voltage input node.

8. The optical receiver of claim 7, wherein the second branch (204) comprises a second logic gate (218) having an input node coupled to the input (206) and having a first supply voltage input node coupled to the first supply voltage rail (VDD) via a second current source (304), wherein the photodiode (112) is coupled between the first supply voltage input nodes of the second logic gates of the first and second branches (202, 204).

9. The optical receiver of any of claims 2 to 8, wherein the photodiode (112) is coupled between the first and second branches (202, 204).

10. The optical receiver of any of claims 2 to 9, wherein the relative phase detector (214) is adapted to detect the relative phases of rising edges of the first and second modified timing signals, the optical receiver further comprising:
a third branch coupled to the input (206) and comprising at least one logic gate (702) adapted to propagate the timing signal and generate a third modified timing signal (IN1');
a fourth branch coupled to the input (206) and comprising at least one logic gate (704) adapted to propagate the timing signal and generate a fourth modified timing signal (IN2'); and
a further relative phase detector (710) adapted to generate a further data signal by detecting the relative phases of falling edges of the third and fourth modified timing signals.

11. The optical receiver of claim 10, wherein the photodiode (112) is coupled so that the current signal causes a change in the slope of a first rising edge of the timing signal propagating through at least one of the first and second branches (202, 204), and of a first falling edge of the timing signal propagating through at least one of the third and fourth branches, and wherein the first and second branches each comprise a first comparator (210, 218) adapted to generate a voltage transition at its output when the voltage at its input crosses a threshold level, wherein the first comparators are adapted such that the threshold level is at least 10 percent higher than a mid-point between the first and second voltage levels, and wherein the third and fourth branches each comprise a second comparator (702, 704) adapted to generate a voltage transition at its output when the voltage at its input crosses a threshold level, wherein the second comparators are adapted such that the threshold level is at least 10 percent lower than a mid-point between the first and second voltage levels.

12. The optical receiver of claim 11, wherein the first and second comparators (210, 218, 702, 704) are formed by inverters.

13. The optical receiver of any of claims 2 to 12, wherein the relative phase detector (214) comprises an early-late detector comprising:
a bi-stable storage device formed of a pair of inverters (602, 604) cross-coupled between first and second output nodes (OUT1, OUT2) of the early-late detector;
at least one first switch (610) coupled between the first and second output nodes (OUT1, OUT2) and controlled based on the first and second modified timing signals (IN1, IN2);
a second switch (606) controlled based on the first modified timing signal (IN1) and coupled between the first node (OUT1) and a first supply voltage rail; and
a third switch (608) controlled based on the second modified timing signal (IN2) and coupled between the second node (OUT2) and the first supply voltage rail.

14. The optical receiver of claim 13, wherein the at least one first switch comprises a pair of first switches (610, 612) coupled in series between the first and second output nodes (OUT1, OUT2), a first switch (610) of the pair being controlled based on the first modified timing signal (IN1), and a second switch (612) of the pair being controlled based on the second modified timing signal (IN2).

15. The optical receiver of claim 14, wherein the at least one first switch further comprises a further switch (613) coupled between the switches of the pair of first switches (610, 612) and controlled by an activation signal (φ1) to selectively activate the relative phase detector (214).
